# EUROPÄISCHE PATENTSCHRIFT

(11) **EP 2 438 633 B1**
(45) Veröffentlichungstag und Bekanntmachung des Hinweises auf die Patenterteilung: **26.05.2021**
(21) Anmeldenummer: 10725079.7
(22) Anmeldetag: 07.06.2010
(51) Int. Cl.: H01L 51/42, H01L 51/48

(54) **PHOTOAKTIVES BAUELEMENT MIT INVERTIERTER SCHICHTFOLGE UND VERFAHREN ZU SEINER HERSTELLUNG**
PHOTOACTIVE COMPONENT COMPRISING AN INVERTED LAYER SEQUENCE, AND METHOD FOR THE PRODUCTION OF SAID COMPONENT
COMPOSANT PHOTOACTIF À SUCCESSION INVERSE DE COUCHES ET SON PROCÉDÉ DE FABRICATION

(30) Priorität: 05.06.2009 DE 102009024294; 29.10.2009 DE 102009051142
(43) Veröffentlichungstag der Anmeldung: 11.04.2012
(73) Patentinhaber: Heliatek GmbH, 01139 Dresden (DE)
(72) Erfinder: MÄNNIG, Bert, 01099 Dresden (DE); UHRICH, Christian, 01307 Dresden (DE); WALZER, Karsten, 01099 Dresden (DE); PFEIFFER, Martin, 01309 Dresden (DE); WYNANDS, David, 01309 Dresden (DE)
(86) Internationale Anmeldenummer: PCT/EP2010/057889
(87) Internationale Veröffentlichungsnummer: WO 2010/139803

(56) Entgegenhaltungen:
- DE-A1-102005 010 978
- SAKAI J ET AL: "Efficient oligothiophene:fullerene bulk heterojunction organic photovoltaic cells" ORGANIC ELECTRONICS, ELSEVIER, AMSTERDAM, NL LNKD- DOI:10.1016/J.ORGEL.2008.03.008, Bd. 9, Nr. 5, 1. Oktober 2008 (2008-10-01) , Seiten 582-590, XP023903476 ISSN: 1566-1199 [gefunden am 2008-03-28]
- DRECHSEL J ET AL: "Efficient organic solar cells based on a double p-i-n architecture using doped wide-gap transport layers" APPLIED PHYSICS LETTERS, AIP, AMERICAN INSTITUTE OF PHYSICS, MELVILLE, NY, US LNKD- DOI:10.1063/1.1935771, Bd. 86, Nr. 24, 7. Juni 2005 (2005-06-07), Seiten 244102-244102, XP012065900 ISSN: 0003-6951
- LINCKER F ET AL: "Fluorenone-based molecules for bulk-heterojunction solar cells: synthesis, characterization, and photovoltaic properties" ADVANCED FUNCTIONAL MATERIALS, WILEY - V C H VERLAG GMBH & CO. KGAA, DE LNKD- DOI:10.1002/ADFM.200800366, Bd. 18, Nr. 21, 1. November 2008 (2008-11-01), Seiten 3444-3453, XP001517163 ISSN: 1616-301X
- WYNANDS D ET AL: "Organic thin film photovoltaic cells based on planar and mixed heterojunctions between fullerene and a low bandgap oligothiophene" J. APPL. PHYS,, Bd. 106, 11. September 2010 (2010-09-11), XP002602392
- RIEDE M K ET AL: "Recent progress in organic solar cells based on small molecules" PROC. OF SPIE,, Bd. 7002, 1. Januar 2008 (2008-01-01), XP002602391
- STOLZ ROMAN L ET AL: "TRAPPING LIGHT IN POLYMER PHOTODIODES WITH SOFT EMBOSSED GRATINGS" ADVANCED MATERIALS, WILEY VCH VERLAG, DE LNKD- DOI:10.1002/(SICI)1521-4095(200002)12:3&LT ,189::AID-ADMA189&GT,3.0.CO,2-, Bd. 12, Nr. 3, 3. Februar 2000 (2000-02-03), Seiten 189-195, XP000923550 ISSN: 0935-9648

## Beschreibung

Die Erfindung betrifft ein photoaktives Bauelement mit organischen Schichten, insbesondere eine Solarzelle nach dem Oberbegriff des Anspruch 1.

Seit der Demonstration der ersten organischen Solarzelle mit einem Wirkungsgrad im Prozentbereich durch Tang et al. 1986 [C.W. Tang et al. Appl. Phys. Lett. 48, 183 (1986)], werden organische Materialien intensiv für verschiedene elektronische und optoelektronische Bauelemente untersucht. Organische Solarzellen bestehen aus einer Folge dünner Schichten (typischerweise 1nm bis 1µm) aus organischen Materialien, welche bevorzugt im Vakuum aufgedampft oder aus einer Lösung aufgeschleudert werden. Die elektrische Kontaktierung kann durch Metallschichten, transparente leitfähige Oxide (TCOs) und/oder transparente leitfähige Polymere (PEDOT-PSS, PANI) erfolgen.

Eine Solarzelle wandelt Lichtenergie in elektrische Energie um. Der Begriff photoaktiv bezeichnet hierbei ebenfalls die Umwandlung von Lichtenergie in elektrische Energie. Im Gegensatz zu anorganischen Solarzellen werden bei organischen Solarzellen durch das Licht nicht direkt freie Ladungsträger erzeugt, sondern es bilden sich zunächst Exzitonen, also elektrisch neutrale Anregungszustände (gebundene Elektron-Loch-Paare). Erst in einem zweiten Schritt werden diese Exzitonen in freie Ladungsträger getrennt, die dann zum elektrischen Stromfluß beitragen.

Der Vorteil solcher Bauelemente auf organischer Basis gegenüber den konventionellen Bauelementen auf anorganischer Basis (Halbleiter wie Silizium, Galliumarsenid) sind die teilweise extrem hohen optischen Absorptionskoeffizienten (bis zu 2x10⁵ cm⁻¹), so dass sich die Möglichkeit bietet, mit geringem Material- und Energieaufwand sehr dünne Solarzellen herzustellen. Weitere technologische Aspekte sind die niedrigen Kosten, die Möglichkeit, flexible großflächige Bauteile auf Plastikfolien herzustellen, und die nahezu unbegrenzten Variationsmöglichkeiten und die unbegrenzte Verfügbarkeit der organischen Chemie.

Eine in der Literatur bereits vorgeschlagene Realisierungsmöglichkeit einer organischen Solarzelle besteht in einer pin -Diode [Martin Pfeiffer, "Controlled doping of organic vacuum deposited dye layers: basics and applications", PhD thesis TU-Dresden, 1999.] mit folgendem Schichtaufbau:
0. Träger, Substrat,
1. Grundkontakt, meist transparent,
2. p- Schicht(en),
3. i- Schicht(en),
4. n- Schicht(en),
5. Deckkontakt.

Hierbei bedeutet n bzw. p eine n- bzw. p-Dotierung, die zu einer Erhöhung der Dichte freier Elektronen bzw. Löcher im thermischen Gleichgewichtszustand führt. Es ist allerdings auch möglich, dass die n-Schicht(en) bzw. p-Schicht(en) nominell undotiert sind und nur aufgrund der Materialeigenschaften (z.B. unterschiedliche Beweglichkeiten), aufgrund unbekannter Verunreinigungen (z.B. verbliebene Reste aus der Synthese, Zerfalls- oder Reaktionsprodukte während der Schichtherstellung) oder aufgrund von Einflüssen der Umgebung (z.B. angrenzende Schichten, Eindiffusion von Metallen oder anderen organischen Materialien, Gasdotierung aus der Umgebungsatmosphäre) bevorzugt n-leitende bzw. bevorzugt p-leitende Eigenschaften besitzen. In diesem Sinne sind derartigen Schichten primär als Transportschichten zu verstehen. Die Bezeichnung i-Schicht bezeichnet demgegenüber eine nominell undotierte Schicht (intrinsische Schicht). Eine oder mehrere i-Schichten können hierbei Schichten sowohl aus einem Material, als auch eine Mischung aus zwei Materialien (sogenannte interpenetrierende Netzwerke bzw. bulkheterojunction; M. Hiramoto et al. Mol. Cryst. Liq. Cryst., 2006, 444, pp. 33-40) bestehen. Das durch den transparenten Grundkontakt einfallende Licht erzeugt in der i-Schicht bzw. in der n-/p-Schicht Exzitonen (gebundene Elektron-Loch-Paare). Diese Exzitonen können nur durch sehr hohe elektrische Felder oder an geeigneten Grenzflächen getrennt werden. In organischen Solarzellen stehen ausreichend hohe Felder nicht zur Verfügung, so dass alle Erfolg versprechenden Konzepte für organische Solarzellen auf der Exzitonentrennung an photoaktiven Grenzflächen beruhen. Die Exzitonen gelangen durch Diffusion an eine derartige aktive Grenzfläche, wo Elektronen und Löcher voneinander getrennt werden. Das Material, welches die Elektronen aufnimmt, wird dabei als Akzeptor, und das Material, welches das Loch aufnimmt, als Donator (oder Donor) bezeichnet. Die trennende Grenzfläche kann zwischen der p- (n-) Schicht und der i-Schicht bzw. zwischen zwei i-Schichten liegen. Im eingebauten elektrischen Feld der Solarzelle werden die Elektronen nun zum n-Gebiet und die Löcher zum p-Gebiet abtransportiert. Vorzugsweise handelt es sich bei den Transportschichten um transparente oder weitgehend transparente Materialien mit großer Bandlücke (wide-gap) wie sie z.B. in WO 2004083958 beschrieben sind. Als wide-gap Materialien werden hierbei Materialien bezeichnet, deren Absorptionsmaximum im Wellenlängenbereich < 450nm liegt, vorzugsweise bei < 400nm. Da durch das Licht immer erst Exzitonen erzeugt werden und noch keine freien Ladungsträger, spielt die rekombinationsarme Diffusion von Exzitonen an die aktive Grenzfläche eine kritische Rolle bei organischen Solarzellen. Um einen Beitrag zum Photostrom zu leisten, muss daher in einer guten organischen Solarzelle die Exzitonendiffusionslänge die typische Eindringtiefe des Lichts deutlich übersteigen, damit der überwiegende Teil des Lichts genutzt werden kann. Strukturell und bezüglich der chemischen Reinheit perfekte organische Kristalle oder Dünnschichten erfüllen durchaus dieses Kriterium. Für großflächige Anwendungen ist allerdings die Verwendung von monokristallinen organischen Materialien nicht möglich und die Herstellung von Mehrfachschichten mit ausreichender struktureller Perfektion ist bis jetzt noch sehr schwierig.

Falls es sich bei der i-Schicht um eine Mischschicht handelt, so übernimmt die Aufgabe der Lichtabsorption entweder nur eine der Komponenten oder auch beide. Der Vorteil von Mischschichten ist, dass die erzeugten Exzitonen nur einen sehr kurzen Weg zurücklegen müssen bis sie an eine Domänengrenze gelangen, wo sie getrennt werden. Der Abtransport der Elektronen bzw. Löcher erfolgt getrennt in den jeweiligen Materialien. Da in der Mischschicht die Materialien überall miteinander im Kontakt sind, ist bei diesem Konzept entscheidend, dass die getrennten Ladungen eine lange Lebensdauer auf dem jeweiligen Material besitzen und von jedem Ort aus geschlossene Perkolationspfade für beide Ladungsträgersorten zum jeweiligen Kontakt hin vorhanden sind.

Aus der US 5,093,698 ist die Dotierung organischer Materialien bekannt. Durch Beimischung einer akzeptorartigen bzw. donatorartigen Dotiersubstanz wird die Gleichgewichtsladungsträgerkonzentration in der Schicht erhöht und die Leitfähigkeit gesteigert. Nach US 5,093,698 werden die dotierten Schichten als Injektionsschichten an der Grenzfläche zu den Kontaktmaterialien in elektrolumineszierenden Bauelementen verwendet. Ähnliche Dotierungsansätze sind analog auch für Solarzellen zweckmäßig.

Aus der Literatur sind verschiedene Realisierungsmöglichkeiten für die photoaktive i-Schicht bekannt. So kann es sich hierbei um eine Doppelschicht (EP0000829) oder eine Mischschicht (Hiramoto, Appl. Phys.Lett. 58,1062 (1991)) handeln. Bekannt ist auch eine Kombination aus Doppel-und Mischschichten (Hiramoto, Appl. Phys.Lett. 58,1062 (1991); US 6,559,375). Ebenfalls bekannt ist, dass das Mischungsverhältnis in verschiedenen Bereichen der Mischschicht unterschiedlich ist (US 20050110005) bzw. das Mischungsverhältnis einen Gradienten aufweist.

DE 10 2005 010 978 A1 beschreibt organische Solarzellen mit zwei angrenzenden Absorberschichten, wobei diese keine intrinsische Schicht besitzen. DRECHSEL J et al., "Efficient organic solar cells based on a double p-i-n architecture using doped wide-gap transport layers", APPLIED PHYSICS LETTERS, vol. 86, no. 24, S. 244102 - 244102, beschreibt pin-Tandem-Solarzellen.

SAKAI J. et al., "Efficient oligothiophene: fullerene bulk heterojunction organic photovoltaic cells", ORGANIC ELECTRONICS, ELSEVIER, AMSTERDAM, NL. vol. 9, no. 5, S. 582 - 590 untersucht die Ladungsträgermobilität bei einem Übergang von Sexithiophenen und C60in einer PIN-, PIM oder MIN-Zelle. WYNANDS D. et al., "Organic thin film photovoltaic cells based on planar and mixed heterojunctions between fullerene and a low bandgap oligothiophene", J. APPL. PHYS" (20100911), vol. 106, XP002602392 [XP] 1-15. untersucht ebenfalls den flachen Heteroübergang von DCV-6T mit C60 in PIN-Zellen, also dem normalen Aufbau.

LINCKER F. et al., "Fluorenone-based molecules for bulkheterojunction solar cells: synthesis, characterization, and photovoltaic properties", ADVANCED FUNCTIONAL MATERIALS, WILEY - V C H VERLAG GMBH & CO. KGAA, DE LNKD-DOI:10.1002/ADFM.200800366, (20081101), vol. 18, no. 21, ISSN 1616-301X, pages 3444 - 3453 untersucht die elektrochemischen und photovoltaischen Eigenschaften von Fluorenonen, die bei der Herstellung von Zellen aus Lösung aufgetragen werden.

Weiterhin ist aus der Literatur bekannt, dass die photoaktiven Mischschichten teilweise kristallin vorliegen können (Hiramoto, MOLECULAR CRYSTALS AND LIQUID CRYSTALS, 444, 33--40 (2006)). Der Grad der Kristallinität kann dabei durch die Wahl der Substrattemperatur während des Aufdampfens geändert werden. Eine erhöhte Substrattemperatur führt normalerweise zu mehr kristallinem Anteil bzw. größeren Kristalliten. Alternativ kann auch nach der Schichtherstellung das Bauelement einer erhöhten Temperatur ausgesetzt werden (Peumans, Nature, 425, 158 (2003)). Dieser Prozess führt normalerweise ebenfalls zu einer erhöhten Kristallinität. Eine andere Möglichkeit die Struktur einer organischen Mischschicht zu beeinflussen, besteht darin, die Methode der organischen Gasphasen-Abscheidung (organic vapor-phase deposition technique, OVPD) zu benutzen (Rusu, Thin Solid Films, 516, 7160-7166 (2008); Rusu, Renewable Energy, 33, 254-258 (2008); Yang, Nature Materials, 4, 37-41, (2005)). Hier wird das organische Material in einem Gasstrom hineingedampft. Der Gasstrom führt dann die Moleküle zum Substrat. Durch Wahl verschiedener Parameter kann die Struktur der abgeschiedenen Schichten und Mischschichten beeinflusst werden.

Weiterhin sind aus der Literatur Solarzellen mit ip-Struktur bekannt (Drechsel, Org. Electron., 5, 175 (2004); J. Drechsel, Synthet. Metal., 127, 201-205 (2002)). Bei der photoaktiven Mischschicht handelt es sich hier um eine Mischschicht aus ZnPc und C60. Diese beiden Materialien haben sehr ähnliche Verdampfungstemperaturen. Das unten beschriebene Problem tritt daher bei diesem System nicht auf, so dass der Inhalt dieses Patentes davon unberührt ist.

Weiterhin sind Tandem- bzw. Mehrfachsolarzellen aus der Literatur bekannt (Hiramoto, Chem. Lett.,1990, 327 (1990); DE 102004014046) .

Bei nicht-polymeren organischen Materialien, so genannten kleinen Molekülen, hängt die Verdampfungstemperatur im Vakuum eng mit den intermolekularen Wechselwirkungen zusammen. Sind diese Wechselwirkungen stark ausgeprägt, führt dies zu einer erhöhten Verdampfungstemperatur.

Unter dem Begriff der Verdampfungstemperatur wird im Sinne der Erfindung diejenige Temperatur verstanden, die benötigt wird, um bei einer gegebenen Verdampfergeometrie (Referenz: Quelle mit einer kreisförmigen Öffnung (1cm Durchmesser) im Abstand von 30cm von einem senkrecht darüber angebrachten Substrat) und einem Vakuum im Bereich 10⁻⁴ bis 10⁻¹⁰ mbar eine Aufdampfrate von 0.1nm/s an der Position des Substrates zu erreichen. Hierbei ist es unerheblich, ob es sich dabei um eine Verdampfung im engeren Sinn (Übergang aus der flüssigen Phase in die Gasphase) oder eine Sublimation handelt.

Bei der Schichtbildung durch Aufdampfen entstehen daher bevorzugt solche Strukturen, bei denen die intermolekularen Wechselwirkungen innerhalb der Schicht maximiert werden, so dass die Grenzflächen, die starke Wechselwirkungen eingehen können an der Schichtoberfläche vermieden werden.

Im Fall von Mischschichten führt das dazu, dass sich an der Oberfläche bevorzugt diejenige Komponente anlagert, die vergleichsweise schwache Wechselwirkungskräfte aufweist, d.h. diese Komponente "schwimmt" bei der Schichtbildung in gewissem Umfang auf. Materialien mit vergleichsweise schwacher Wechselwirkung zwischen den Molekülen zeichnen sich normalerweise durch einen niedrigen Schmelzpunkt (z.B. < 100°C) oder eine niedrige Glasübergangstemperatur (z.B. < 150°C) aus.

Handelt es sich bei der "schwächer wechselwirkenden Komponente" um die Donatorkomponente der Mischschicht besteht eine Tendenz, dass - insbesondere bei Wachstum auf geheiztem Substrat oder bei nachträglichem Tempern - eine sehr dünne Schicht (d.h. zumindest eine Monolage) an der Oberfläche entsteht, die fast ausschließlich aus dem Donatormaterial besteht. Diese Entmischung bzw. dieses "Aufschwimmen" kann auch durch andere Prozesse wie z.B. eine Lösungsmittelbehandlung (während der Herstellung der Schicht oder nachträglich) oder durch die Methode der Abscheidung einer Schicht mittels organischen Gasphasen-Abscheidung (Organic Vapour Phase Deposition (OVPD)) entstehen bzw. unterstützt werden. Die "aufgeschwommene" Monolage der Donatorkomponente weist folglich schlechtere Elektronentransporteigenschaften auf und behindert den Abtransport von photogenerierten Elektronen bei einer pin-Struktur. Ein Abtransport von photogenerierten Löchern in diese Richtung ist dagegen problemlos möglich, da es sich bei der Donatorkomponente ja um ein bevorzugt löchertransportierendes Material handelt.

Das oben beschriebene Problem tritt bevorzugt dann auf, wenn das Donator-Material eine Verdampfungs-Temperatur im Vakuum hat, die um mindestens 150°C tiefer liegt als die Verdampfungs-Temperatur des Akzeptor-Materials im Vakuum, bei einer gegebenen Verdampfergeometrie. Durchaus möglich ist es aber auch, das bereits bei einem Verdampfungsunterschied von 100°C oder weniger, ein "Aufschwimmen" stattfindet.

In der Literatur beschriebene organische Solarzellen aus Vakuumdeposition nicht-polymerer organischer Moleküle, sogenannte kleine Moleküle, sind bis auf wenige Ausnahmen (Drechsel, Org. Electron., 5, 175 (2004); J. Drechsel, Synthet. Metal., 127, 201-205 (2002)) so aufgebaut, dass der sogenannte Grundkontakt, auf dem die organischen Schichten abgeschieden werden, die Anode bildet (falls die Struktur eine ausschließlich löcherleitende oder p-dotierte Schicht umfasst, grenzt diese an den Grundkontakt). Bei der Anode handelt es sich in der Regel um ein transparentes leitfähiges Oxid (oft Indium-Zinn-Oxid, abgekürzt ITO; es kann sich aber auch um ZnO:Al handeln), es kann aber auch eine Metallschicht oder eine Schicht aus einem leitfähigen Polymer sein. Nach Abscheidung des organischen Schichtsystems, welcher die photoaktive Mischschicht umfasst, wird eine - meist metallische - Kathode abgeschieden.

Dieser hier als nicht-invertiert bezeichnete Aufbau hat zur Folge, dass die in der photoaktiven Mischschicht gebildeten Löcher zum Substrat (Anode) hin abgeführt werden müssen, während sich die photogenerierten Elektronen vom Substrat weg in Richtung auf die Kathode bewegen müssen. Dies ist aber, wie oben beschrieben, problematisch, wenn es zum "Aufschwimmen" der Donatorkomponente bei der Abscheidung oder Nachbehandlung der Mischschicht kommt.

Dieses Problem kommt umso mehr zum Tragen, je näher am thermischen Gleichgewicht das Wachstum der Mischschicht stattfindet. Der Vorteil einer verbesserten Ordnung im Volumen bei Wachstum näher am Gleichgewicht (nanokristalline statt amorphe Struktur, vgl. M. Hiramoto et al., Mol. Cryst. Liq. Cryst., 2006, 444, pp. 33-40; M. Rusu et al., Thin Solid Film, 2008, 516, pp. 7160-7166) wird deshalb durch ein zunehmendes Problem an der Grenzfläche konterkariert.

Das Problem besteht also darin, bei einer Donator-Akzeptor-Kombination, bei der zumindest ein teilweises "Aufschwimmen" des Donatormaterials in der Mischschicht stattfindet, sowohl eine gute Ordnung in der Mischschicht zu erzielen und gleichzeitig keine Transportprobleme an der Grenzfläche der Mischschicht zu bekommen.

Der Erfindung liegt somit die Aufgabe zugrunde, ein photoaktives Bauelement anzugeben, dass die vorbeschriebenen Nachteile überwindet und dabei eine erhöhte Effizienz des Bauelementes und möglichst eine verbesserte Lebensdauer aufweist. Eine weitere Aufgabe der Erfindung liegt darin, ein Verfahren zur Herstellung eines solchen photoaktiven Bauelements anzugeben.

Die Aufgabe wird durch ein photoaktives Bauelement gemäß dem Anspruch 1 gelöst, wobei das organische photoaktive Bauelement mindestens einem photoaktiven intrinsischen Schichtsystem zwischen der Anode und der Kathode zur Erzeugung von gebundenen Elektron-Loch-Paaren enthält, wobei das photoaktive i-Schichtsystem mindestens eine Mischschicht aus mindestens einem Donator- und mindestens einem Akzeptor-Material, die ein Donator-Akzeptor-System bilden, enthält, und diese Materialien nicht polymer sind, und das Donator-Material eine Verdampfungstemperatur im Vakuum aufweist, die um mindestens 150°C tiefer liegt als die Verdampfungstemperatur im Vakuum des Akzeptor-Materials, und das Bauelement eine invertierte Stuktur (nip, ip oder ni) aufweist, so dass die photogenerierten Elektronen die Mischschicht in Richtung des Substrats verlassen.

Vorteilhafte Ausgestaltungen sind in den Unteransprüchen angegeben.

Erfindungsgemäß wird die Aufgabenstellung dadurch gelöst, indem man zu einer invertierten Schichtfolge übergeht, bei der die Abscheidung auf der Kathode (n-Seite unten, z.B. n-i-p Struktur) stattfindet und die photogenerierten Elektronen die Mischschicht damit in Richtung auf das Substrat hin verlassen müssen und die photogenerierten Elektronen in Richtung der Gegenelektrode, was beides problemlos möglich ist.

Das hier postulierte Problem des "Aufschwimmens" weniger Monolagen ist spektroskopisch mit heutigen Mitteln kaum nachweisbar. Daher wurde das Problem bisher nicht erkannt und die hier vorgeschlagene Problemlösung bisher von der Fachwelt nicht in Erwägung gezogen.

Eine bevorzugte Ausführungsform der Erfindung besteht als organische nip-Solarzelle bzw. organische nipnip-Tandemsolarzelle oder nip-Mehrfachsolarzelle, wie sie in der WO 2004083958 dargestellt ist.

Für die oben beschriebene invertierte Struktur (n-i-p, i-p oder n-i Struktur) kann es sein, dass im Bauelement Kontaktprobleme an der auf dem Substrat befindlichen Elektrode und /oder der Gegenelektrode auftreten: Normalerweise hat in der klassischen p-i-n Struktur die auf dem Substrat befindliche Elektrode einen Kontakt zur p-Schicht und die Gegenelektrode einen Kontakt zur n-Schicht. Diese Kontakte funktionieren sehr gut bzw. die Kontaktsysteme und Kontaktmaterialien sind inzwischen optimiert worden, so dass hier keine Verluste auftreten. Als mögliche Lösung für die invertierte Struktur können die beiden neuen Kontaktsysteme Elektrode/n-Schicht und p-Schicht/Gegenelektrode nun neu optimiert werden (z.B. durch geeignete Wahl der Materialien bzw. geeignete Herstellungsbedingungen). Eine andere Lösungsmöglichkeit besteht darin, an den Elektroden einen Konversionskontakt (pn oder np) einzubauen, so dass man wiederum die alten Kontaktsysteme Elektrode/p-Schicht und n-Schicht/Gegenelektrode erhält. Mögliche Strukturen sind hierfür z.B. pnip, nipn oder pnipn.

Eine weitere Ausführungsform des erfindungsgemäßen Bauelementes besteht darin, dass zwischen der ersten elektronenleitenden Schicht (n-Schicht) und der auf dem Substrat befindlichen Elektrode noch eine p-dotierte Schicht vorhanden ist, so dass es sich um eine pnip oder pni-Struktur handelt, wobei vorzugsweise die Dotierung so hoch gewählt ist, dass der direkte pn-Kontakt keine sperrende Wirkung hat, sondern es zu verlustarmer Rekombination, bevorzugt durch einen Tunnelprozess kommt.

In einer weiteren Ausführungsform der Erfindung kann in dem Bauelement zwischen der photoaktiven i-Schicht und der auf dem Substrat befindlichen Elektrode noch eine p-dotierte Schicht vorhanden sein, so dass es sich um eine pip oder pi-Struktur handelt, wobei die zusätzliche p-dotierte Schicht eine Ferminiveaulage hat, die höchstens 0,4eV, bevorzugt aber weniger als 0,3eV unterhalb des Elektronentransportniveaus der i-Schicht liegt, so dass es zu verlustarmer Elektronenextraktion aus der i-Schicht in diese p-Schicht kommen kann.

Eine weitere Ausführungsform des erfindungsgemäßen Bauelementes besteht darin, dass noch ein n-Schichtsystem zwischen der p-dotierten Schicht und der Gegenelektrode vorhanden ist, so dass es sich um eine nipn oder ipn-Struktur handelt, wobei vorzugsweise die Dotierung so hoch gewählt ist, dass der direkte pn-Kontakt keine sperrende Wirkung hat, sondern es zu verlustarmer Rekombination, bevorzugt durch einen Tunnelprozess kommt.

In einer weiteren Ausführungsform kann in dem Bauelement noch ein n-Schichtsystem zwischen der intrinsischen, photoaktiven Schicht und der Gegenelektrode vorhanden sein, so dass es sich um eine nin- oder in-Struktur handelt, wobei die zusätzliche n-dotierte Schicht eine Ferminiveaulage hat, die höchstens 0,4eV, bevorzugt aber weniger als 0,3eV oberhalb des Löchertransportnivaus der i-Schicht liegt, so dass es zu verlustarmer Löcherextraktion aus der i-Schicht in diese n-Schicht kommen kann.

Eine weitere Ausführungsform des erfindungsgemäßen Bauelementes besteht darin, dass das Bauelement ein n-Schichtsystem und/oder ein p-Schichtsystem enthält, so dass es sich um eine pnipn, pnin, pipn- oder p-i-n-Struktur handelt, die sich in allen Fällen dadurch auszeichnen, dass - unabhängig vom Leitungstyp - die substratseitig an die photoaktive i-Schicht angrenzende Schicht eine geringere thermische Austrittsarbeit hat als die vom Substrat abgewandte an die i-Schicht grenzende Schicht, so dass photogenerierte Elektronen bevorzugt zum Substrat hin abtransportiert werden, wenn keine externe Spannung an das Bauelement angelegt wird.

In einer weiteren Ausführungsform der Erfindung werden mehrere Konversionskontakte hintereinandergeschaltet, so dass es sich z.B. um eine npnipn, pnipnp, npnipnp, pnpnipnpn oder pnpnpnipnpnpn Struktur handelt.

In einer bevorzugten Weiterbildung der oben beschriebenen Strukturen sind diese als organische Tandemsolarzelle oder Mehrfachsolarzelle ausgeführt. So kann es sich bei dem Bauelement um eine Tandemzelle aus einer Kombination aus nip, ni, ip, pnip, pni, pip, nipn, nin, ipn, pnipn, pnin oder pipn-Strukturen handeln, bei der mehrere unabhängige Kombinationen, die mindestens eine i-Schicht enthalten, übereinander gestapelt sind (Kreuzkombinationen).

In einer besonders bevorzugten Ausführungsform der oben beschriebenen Strukturen ist diese als eine pnipnipn-Tandemzelle ausgeführt.

Besonders wichtig in derartigen Stapelzellen ist die Balance der erzeugten Ströme in den Einzelzellen, d.h. die Anzahl der absorbierten und in Ladungsträger umgewandelten Photonen. Sollte z.B. bei einer pinpin-Tandemzelle mit zwei verschiedenen Absorbersystemen bei einer Mischschicht das oben beschriebene "Aufschwimm"-Problem auftreten, diese Mischschicht daher weniger Strom erzeugen bzw. über einen schlechteren Füllfaktor verfügen und dadurch die Tandemsolarzelle stark in ihren Eigenschaften vermindert werden (die schwächere Teilzelle limitiert mit ihrem geringeren erzeugten Strom bzw. schlechteren Füllfaktor (FF) das ganze Bauelement, d.h. auch die andere Teilzelle kann ihr Potential nicht mehr ausschöpfen) so wird das Problem erfindungsgemäß dadurch gelöst, dass zu einer invertierten nipnip-Struktur oder zu einer anderen der oben beschriebenen Strukturen gewechselt wird.

In einer weiteren Ausführungsform der Erfindung werden bei einer Tandem- oder Mehrfachzelle eine gewisse Anzahl der i-Mischschichten auf geheiztem Substrat (bevorzugt zwischen 70°C und 140°C) hergestellt werden und die restlichen i-Mischschichten, während das Substrat eine geringere Temperatur (bevorzugt < 60°C) oder Raumtemperatur hat. Hierbei ist es auch möglich, dass die Herstellung der i-Mischschichten abwechselnd auf geheiztem Substrat und bei niedrigeren Temperaturen bzw. Raumtemperatur erfolgt, indem das Substrat abwechselnd geheizt und wieder abgekühlt wird.

In einer weiteren Ausführungsform ist das organische photoaktive Bauelement als eine organische Solarzelle ausgeführt, die mit einer Elektrode und einer Gegenelektrode und zwischen den Elektroden mindestens einem organischen photoaktiven i-Schichtsystem ausgeführt ist. Dieses photoaktive i-Schichtsystem enthält mindestens eine Mischschicht aus einem Donator-Material und einem Akzeptor-Material, welche ein Donator-Akzeptor-System bilden. Das Donator- und Akzeptor-Material der Mischschicht enthält nicht-polymere Materialien, sogenannte kleine Moleküle. Weiterhin weist das Donator-Material eine Verdampfungs-Temperatur im Vakuum auf, die um mindestens 150°C tiefer liegt als die Verdampfungs-Temperatur des Akzeptor-Materials. Die organische Solarzelle weist eine invertierte Schichtfolge auf. Diese kann als eine n-i-p, i-p oder n-i Struktur aus jeweils einem n-, i- oder p-Schichtsystem ausgebildet sein, wobei das organische photoaktive i-Schichtsystem entweder direkt auf der Kathode oder auf einem elektronenleitenden n-Materialsystem aufgebracht ist.

In einer weiteren Ausführungsform liegt das Akzeptor-Material in der Mischschicht zumindest teilweise in kristalliner Form vor.

In einer weiteren Ausführungsform liegt das Donator-Material in der Mischschicht zumindest teilweise in kristalliner Form vor.

In einer weiteren Ausführungsform liegen sowohl das Akzeptor-Material als auch das Donator-Material in der Mischschicht zumindest teilweise in kristalliner Form vor.

In einer weiteren Ausführungsform verfügt das Akzeptor-Material über ein Absorptionsmaximum im Wellenlängenbereich > 450nm.

In einer weiteren Ausführungsform verfügt das Donator-Material über ein Absorptionsmaximum im Wellenlängenbereich > 450nm.

In einer weiteren Ausführungsform enthält das photoaktive i-Schichtsystem zusätzlich zu der genannten Mischschicht noch weitere photoaktive Einzel- oder Mischschichten.

In einer weiteren Ausführungsform besteht das n-Materialsystem aus einer oder mehreren Schichten.

In einer weiteren Ausführungsform besteht das p-Materialsystem aus einer oder mehreren Schichten.

In einer weiteren Ausführungsform enthält das n-Materialsystem eine oder mehrere dotierte wide-gap Schichten. Der Begriff wide-gap Schichten definiert dabei Schichten mit einem Absorptionsmaximum im Wellenlängenbereich <450nm.

In einer weiteren Ausführungsform enthält das p-Materialsystem eine oder mehrere dotierte wide-gap Schichten.

In einer weiteren Ausführungsform sind Lichtfallen zur Vergrößerung optische Weg des einfallenden Lichtes im aktiven System ausgebildet.

In einer weiteren Ausführungsform wird die Lichtfalle dadurch realisiert, dass eine dotierte wide-gap-Schicht eine glatte Grenzfläche zur i-Schicht und eine periodisch mikrostrukturierte Grenzfläche zum Kontakt hat.

In einer weiteren Ausführungsform wird die Lichtfalle dadurch realisiert, dass das Bauelement auf einem periodisch mikrostrukturierten Substrat aufgebaut wird und die homogene Funktion des Bauelements, also eine kurzschlussfreie Kontaktierung und homogene Verteilung des elektrischen Feldes über die gesamte Fläche, durch die Verwendung einer dotierten wide-gap-Schicht gewährleistet wird. Ultradünne Bauelemente weisen auf strukturierten Substraten eine erhöhten Gefahr zur Bildung lokaler Kurzschlüsse auf, so dass durch eine solche offensichtliche Inhomogenität letztlich die Funktionalität des gesamten Bauelements gefährdet ist. Diese Kurzschlussgefahr wird durch die Verwendung der dotierten Transportschichten verringert.

In einer weiteren Ausführungsform enthält das Bauelement zwischen der ersten elektronenleitenden Schicht (n-Schicht) und der auf dem Substrat befindlichen Elektrode eine p-dotierte Schicht, so dass es sich um eine pnip oder pni-Struktur handelt.

In einer weiteren Ausführungsform enthält das Bauelement zwischen der photoaktiven i-Schicht und der auf dem Substrat befindlichen Elektrode eine p-dotierte Schicht, so dass es sich um eine pip oder pi-Struktur handelt, wobei die zusätzliche p-dotierte Schicht eine Ferminiveaulage hat, die höchstens 0,4eV, bevorzugt aber weniger als 0,3eV unterhalb des Elektronentransportnivaus der i-Schicht liegt.

In einer weiteren Ausführungsform enthält das Bauelement ein n-Schichtsystem zwischen der p-dotierten Schicht und der Gegenelektrode, so dass es sich um eine nipn oder ipn-Struktur handelt.

In einer weiteren Ausführungsform enthält das Bauelement ein n-Schichtsystem zwischen der photoaktiven i-Schicht und der Gegenelektrode, so dass es sich um eine nin- oder in-Struktur handelt, wobei die zusätzliche n-dotierte Schicht eine Ferminiveaulage hat, die höchstens 0,4eV, bevorzugt aber weniger als 0,3eV oberhalb des Löchertransportnivaus der i-Schicht liegt.

In einer weiteren Ausführungsform enthält das Bauelement ein n-Schichtsystem und/oder ein p-Schichtsystem, so dass es sich um eine pnipn, pnin, pipn- oder p-i-n-Struktur handelt.

In einer weiteren Ausführungsform enthält das zusätzliche p-Materialsystem und/oder das zusätzliche n-Materialsystem eine oder mehrere dotierte wide-gap Schichten.

In einer weiteren Ausführungsform enthält das Bauelement noch weitere n-Schichtsysteme und/oder p-Schichtsysteme, so das es sich z.B. um eine npnipn, pnipnp, npnipnp, pnpnipnpn oder pnpnpnipnpnpn -Struktur handelt.

In einer weiteren Ausführungsform eines oder mehrere der weiteren p-Materialsysteme und/oder der weiteren n-Materialsysteme eine oder mehrere dotierte wide-gap Schichten enthält.

In einer weiteren Ausführungsform enthält das Bauelement noch weitere n-Schichtsysteme und/oder p-Schichtsysteme, so das es sich z.B. um eine npnipn, pnipnp, npnipnp, pnpnipnpn oder pnpnpnipnpnpn -Struktur handelt.

In einer weiteren Ausführungsform enthält eines oder mehrere der weiteren p-Materialsysteme und/oder der weiteren n-Materialsysteme eine oder mehrere dotierte wide-gap Schichten.

In einer weiteren Ausführungsform handelt es sich bei dem Bauelement um eine Tandem- oder Mehrfachstruktur.

In einer weiteren Ausführungsform handelt es sich bei dem Bauelement um eine Tandemzelle aus einer Kombination aus nip, ni, ip, pnip, pni, pip, nipn, nin, ipn, pnipn, pnin oder pipn-Strukturen.

In einer weiteren Ausführungsform handelt es sich bei den verwendeten organischen Materialien um kleine Moleküle. Unter dem Begriff kleine Moleküle werden im Sinne der Erfindung Monomere verstanden, die verdampft und damit auf dem Substrat abgeschieden werden können.

In einer weiteren Ausführungsform handelt es sich bei den organischen Materialien zumindest teilweise um Polymere, wobei aber zumindest eine photoaktive i-Schicht aus kleinen Molekülen gebildet ist.

In einer weiteren Ausführungsform ist das Akzeptor-Material ein Material aus der Gruppe der Fullerene bzw. Fullerenderivate (bevorzugt C60 oder C70) oder ein PTCDI-Derivat (Perylen-3,4,9,10-bis(dicarboximid)-Derivat).

In einer weiteren Ausführungsform ist das Donator-Material ein Oligomer, insbesondere ein Oligomer nach WO2006092134, ein Porphyrin-Derivat, ein Pentacen-Derivat oder ein Perylenderivat, wie DIP (Di-Indeno-Perylen), DBP (Di-benzoperylene).

In einer weiteren Ausführungsform enthält das p-Materialsystem ein TPD-Derivat(Triphenylamin-Dimer), eine Spiro-Verbindung, wie Spiropyrane, Spiroxazine, MeO-TPD (N,N,N',N'-Tetrakis(4-methoxyphenyl)-benzidin), Di-NPB (N,N'diphenyl-N,N'-bis(N,N'-*di*(1-naphthyl)-N,N'-diphenyl-(1,1'-biphenyl) 4,4'-diamine), MTDATA (4,4',4"-Tris-(N-3-methylphenyl-N-phenyl-amino)-triphenylamin), TNATA (4,4',4"-Tris[N-(1-naphthyl)-N-phenyl-amino]-triphenylamin), BPAPF (9,9-bis{4-[di-(p-biphenyl)aminophenyl]}fluorene), NPAPF (9,9-Bis[4-(N,N'-bis-naphthalen-2-yl-amino)phenyl]-9H-fluorene), Spiro-TAD (2,2',7,7'-Tetrakis-(diphenylamino)-9,9'-spirobifluoren), PV-TPD (N,N-di 4-2,2-diphenyl-ethen-1-yl-phenyl-N,N-di 4-methylphenylphenylbenzidine), 4P-TPD (4,4'-bis-(N,N-diphenylamino)-tetraphenyl), oder ein in DE102004014046 beschriebenes p-Material.

In einer weiteren Ausführungsform enthält das n-Materialsystem Fullerene, wie beispielsweise C60, C70; NTCDA (1,4,5,8-Naphthalene-tetracarboxylic-dianhydride), NTCDI (Naphthalenetetracarboxylic diimide) oder PTCDI (Perylen-3,4,9,10-bis(dicarboximid) .

In einer weiteren Ausführungsform enthält das p-Materialsystem einen p-Dotanden, wobei dieser p-Dotand F4-TCNQ, ein p-Dotand wie in DE10338406, DE10347856, DE10357044, DE102004010954, DE102006053320, DE102006054524 und DE102008051737 beschrieben oder ein Übergangsmetalloxid (VO, WO, MoO, etc.) ist.

In einer weiteren Ausführungsform enthält das n-Materialsystem einen n-Dotanden, wobei dieser n-Dotand ein TTF-Derivat (Tetrathiafulvalen-Derivat) oder DTT-Derivat (dithienothiophen), ein n-Dotand wie in DE10338406, DE10347856, DE10357044, DE102004010954, DE102006053320, DE102006054524 und DE102008051737 beschrieben oder Cs, Li oder Mg ist.

In einer weiteren Ausführungsform ist eine Elektrode transparent mit einer Transmission > 80% und die andere Elektrode reflektierend mit einer Reflektion > 50% ausgeführt.

In einer weiteren Ausführungsform ist das Bauelement semitransparent mit einer Transmission von 10-80% ausgeführt.

In einer weiteren Ausführungsform bestehen die Elektroden aus einem Metall (z.B. Al, Ag, Au oder eine Kombination aus diesen), einem leitfähigen Oxid, insbesondere ITO, ZnO:Al oder einem anderen TCO (Transparent Conductive Oxide), einem leitfähigen Polymer, insbesondere PEDOT/PSS Poly(3,4-ethylenedioxythiophene)poly(styrenesulfonate) oder PANI (Polyanilin), oder aus einer Kombination aus diesen Materialien.

In einer weiteren Ausführungsform weisen die verwendeten organischen Materialien einen niedrigem Schmelzpunkt, bevorzugt < 100°C, auf.

In einer weiteren Ausführungsform weisen die verwendeten organischen Materialien eine niedrige Glasübergangstemperatur, bevorzugt < 150°C, auf.

In einer weiteren Ausführungsform weisen die verwendeten organischen Materialien mehrere Kristallphasen auf und besitzen eine Phasenumwandlungstemperatur, welche ähnlich (+/-30°C) der Substrattemperatur bei der Abscheidung bzw. der Temperatur des nachträglichen Temperns ist. Unter Tempern wird die Erhitzung eines Festkörpers auf eine Temperatur unterhalb der Schmelztemperatur verstanden. Dies geschieht über eine längere Zeit hinweg (einige Minuten bis hin zu einigen Tagen), wobei Strukturdefekte ausgeglichen werden und die Kristallstruktur in der Nah- und Fernordnung verbessert wird. Somit wird der Prozess des Schmelzens und extrem langsamen Abkühlens zur Einstellung der Kristallstruktur vermieden.

In einer weiteren Ausführungsform erfolgt die Abscheidung der Mischschicht mittels der der Methode der organischen Gasphasen-Abscheidung (Organic Vapour Phase Deposition (OVPD)) .

In einer weiteren Ausführungsform erfolgt die Abscheidung der Mischschicht auf einem geheiztem Substrat, welches vorzugsweise eine Temperatur > 80°C aufweist.

In einer weiteren Ausführungsform wird Mischschicht nach der Abscheidung getempert, wobei die Temper-Temperatur mindestens 20°C über der Substrat-Temperatur bei der Abscheidung liegt.

In einer weiteren Ausführungsform erfolgt eine Behandlung der Mischschicht mit Lösungsmitteldämpfen während oder nach der Herstellung.

In einer weiteren Ausführungsform werden bei einer Tandem-oder Mehrfachzelle eine gewisse Anzahl der i-Schichten auf geheiztem Substrat (bevorzugt zwischen 70°C und 140°C) hergestellt und die restlichen i-Schichten hergestellt werden, während das Substrat eine geringere Temperatur (bevorzugt < 60°C) oder Raumtemperatur besitzt.

Nachfolgend soll die Erfindung anhand von Ausführungsbeispielen eingehender erläutert werden. Es zeigen in den dazugehörigen Figuren in
Fig. 1 eine Darstellung einer Röntgenbeugungsmessung (XRD) an DCV5T-Filmen (auf Si100),
Fig. 2 eine Strom-Spannungskennlinie für eine pin-Solarzelle mit Mischschicht DCV5T:C60 bei 90°C Substrattemperatur und bei Raumtemperatur hergestellt,
Fig. 3 eine Strom-Spannungskennlinie für eine nip-Solarzelle mit Mischschicht DCV5T:C60 bei 90°C Substrattemperatur und bei Raumtemperatur hergestellt,
Fig. 4 eine Strom-Spannungskennlinie für eine mip-Solarzelle mit Mischschicht DCV5T:C60 bei 90°C Substrattemperatur hergestellt,
Fig. 5 eine Strom-Spannungskennlinie für eine mip-Solarzelle mit mit verschiedenen Schichtdicken der Mischschichten DCV5T:C60 hergestellt bei Raumtemperatur, in
Fig. 6 eine Strom-Spannungskennlinie für eine mip-Solarzelle mit verschiedenen Schichtdicken der Mischschichten DCV5T:C60 hergestellt bei 90°C Substrattemperatur hergestellt und in
Fig. 7 eine Strom-Spannungskennlinie für eine Pnipnipn-Tandemzelle mit Mischschichten ZnPc:C60 und DCV5T:C60, wobei die Mischschichten bei 30°C bzw. 90°C Substrattemperatur hergestellt worden sind.

### Ausführungsbeispiel a)

Nachweis Kristallinität der Mischschicht DCV5T:C60, hergestellt bei 90°C Substrattemperatur:

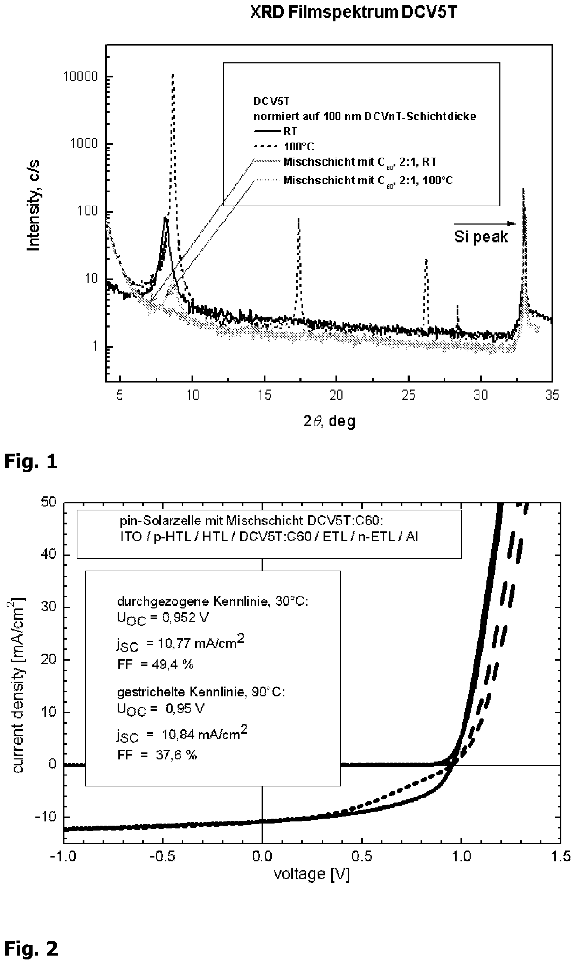

Die Fig. 1 zeigt eine Röntgenbeugungsmessung (XRD) an DCV5T-Filmen (auf Si100). Die reine DCV5T-Schicht (αα'-Bis (2,2-dicyanovinyl)quin-quethiophene-Schicht)(gestrichelte und dunkle durchgezogene Linie) zeigt einen Peak bei 8,15° bzw. 8,65°. Der Peak ist bei der Probe, die auf ein geheiztes Substrat (100°C) aufgedampft worden ist, deutlich größer (gestrichelte Linie) im Vergleich zu der Probe, die bei Raumtemperatur (RT; dunkle durchgezogene Linie) abgeschieden worden ist. Die Ordnung bzw. Kristallinität ist daher bei der 100°C Probe deutlich gestiegen. Bei den Mischschichten mit C60 ist der Grad der Kristallinität stark vermindert. Das Spektrum der Mischschicht bei RT (RT=Raumtemperatur) zeigt überhaupt keinen Peak. Durch Aufdampfen auf ein geheiztes Substrat bei 100°C lässt sich auch in der Mischschicht wieder eine Kristallinität erhalten, wenn auch noch nicht so gut wie in den Einzelschichten, weshalb hier nur ein Peak ergibt. Zur besseren Unterscheidung sind die Kurvenverläufe der beiden hergestellten Mischschichten mittels Pfeilen den jeweiligen Substrattemperaturen zugeordnet.

### Vergleichsbeispiel b)

Als Vergleich wird in Fig. 2 eine pin-Solarzelle mit dem Aufbau ITO / p-HTL / HTL / DCV5T:C60 / ETL / n-ETL / Al verwendet. Die Mischschicht DCV5T:C60, wird einmal bei 90°C Substrattemperatur (gestrichelte Kennlinien, Hell- und Dunkelkennlinien) und einmal bei Raumtemperatur (30°C; durchgezogene Kennlinien, Hell- und Dunkelkennlinien)hergestellt.

Die verwendeten Abkürzungen sind wie folgt definiert:
ETL: Elektronentransportschicht (electron transport layer)
HTL: Löchertransportschicht (hole transport layer)
n-ETL: n-dotierte Elektronentransportschicht (electron transport layer)
p-HTL: p-dotierte Löchertransportschicht (hole transport layer)

Deutlich zu sehen ist, dass die Solarzelle, die bei 90°C hergestellt worden ist, über einen schlechten Füllfaktor verfügt. Die Mischschicht DCV5T:C50 verfügt hier zwar über eine höhere Kristallinität, dies führt aber nicht zu einem besseren Bauelement, sondern sogar zu einem schlechteren. Die Ursache ist ein Transportproblem der Elektronen aus der Mischschicht: Zwischen der Mischschicht DCV5T:C60 und der darüberliegenden C60 Schicht hat sich eine sehr dünne (vermutlich nur eine oder wenige Monolagen dicke Schicht) aus DCV5T gebildet, die den Abtransport der Elektronen behindert. Dieses Problem wird dadurch gelöst dass die pin-Struktur herumgedreht wird und eine nip-Struktur verwendet wird.

### Ausführungsbeispiel c)

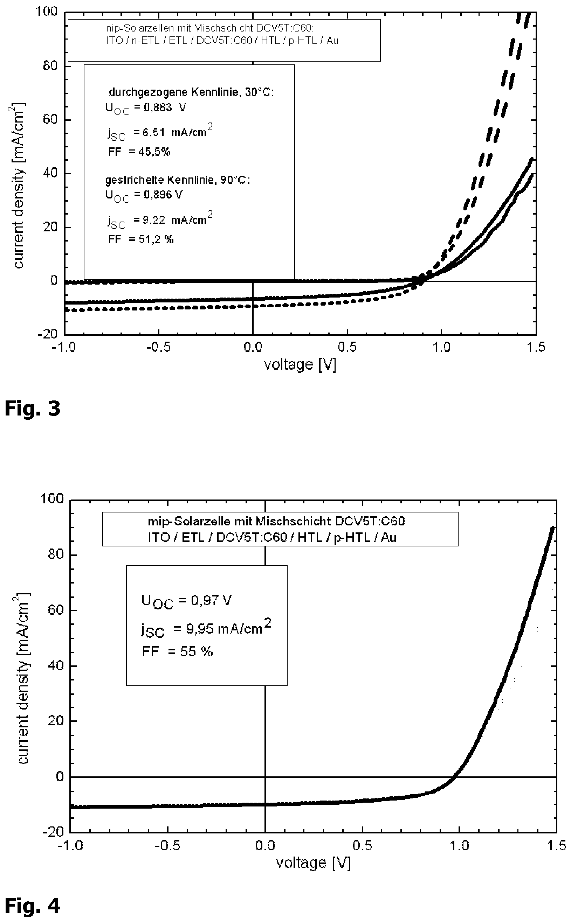

In einem weiteren Ausführungsbeispiel wird in Fig. 3 eine nip-Solarzelle mit dem Aufbau ITO / n-ETL / ETL / DCV5T:C60 / HTL / p-HTL / Au verwendet. Die Mischschicht DCV5T:C60 wird einmal bei 90°C Substrattemperatur (gestrichelte Kennlinien, Hell-und Dunkelkennlinien) und einmal bei Raumtemperatur (30°C; durchgezogene Kennlinien, Hell- und Dunkelkennlinien)hergestellt.

Die Solarzelle, die bei 90°C Substrattemperatur hergestellt worden ist, zeichnet sich sowohl durch einen höheren Kurzschlussstrom als auch einen größeren Füllfaktor aus. Die Ursache liegt in der gestiegenen Kristallinität der Mischschicht DCV5T:C60. Die sehr dünne DCV5T-Schicht, die sich wiederum auf der Mischschicht gebildet hat, stört in diesem Fall nicht, da sie sich jetzt auf der p-Seite des Bauelementes befindet. Im Gegenteil kann diese dünne DCV5T bei diesem nip-Aufbau hier sogar noch zum Photostrom beitragen und damit die Eigenschaften des Bauelementes weiter verbessern.

### Ausführungsbeispiel d)

In einem weiteren Ausführungsbeispiel wird in Fig. 4 eine mip-Solarzelle mit dem Aufbau ITO / ETL / DCV5T:C60 / HTL / p-HTL / Au verwendet. Die Mischschicht DCV5T:C60 wurde bei 90°C Substrattemperatur hergestellt (Hellkennlinie). Auch in einer mip-Struktur lässt sich ein gutes Bauelement mit einem guten Füllfaktor realisieren.

### Ausführungsbeispiel e)

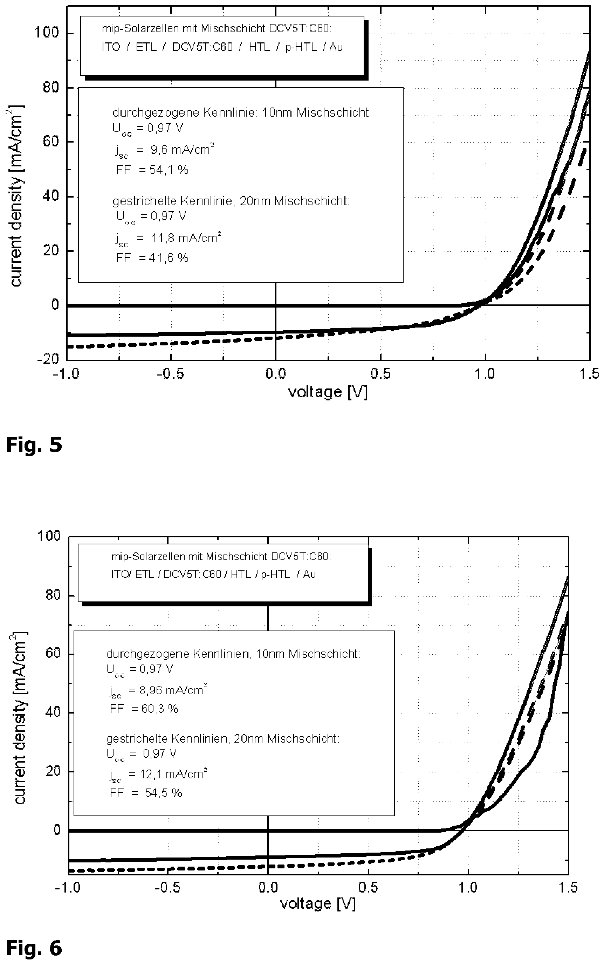

In einem weiteren Ausführungsbeispiel wird in Fig. 5 eine mip-Solarzelle mit dem Aufbau ITO/ C60/ DCV5T:C60/ p-BPAPF/ p-ZnPc(p-Zinkphthalocyanin)/ Au mit unterschiedlichen Schichtdicken der Mischschicht verwendet. Die Mischschichten DCV5T:C60 wurden bei Raumtemperatur (30°C)hergestellt. Die Schichtdicken der Mischschichten betragen 10nm (durchgezogene Kennlinien, Hell- und Dunkelkennlinien) und 20nm (gestrichelte Kennlinien, Hell- und Dunkelkennlinien).

Das Bauelement mit der dickeren Mischschicht ist nicht besser als mit der dünneren Mischschicht, obwohl das erstere mehr Licht absorbiert. Die Ursache ist die schlechte Kristallinität der Mischschicht hergestellt bei Raumtemperatur und die dadurch bedingten Probleme beim Abtransport der Ladungsträger.

### Ausführungsbeispiel f)

In einem weiteren Ausführungsbeispiel wird in Fig. 6 eine mip-Solarzelle mit dem Aufbau ITO / ETL / DCV5T:C60 / HTL / p-HTL / Au mit unterschiedlichen Schichtdicken der Mischschicht verwendet. Die Mischschichten DCV5T:C60 wurden bei 90°C Substrattemperatur hergestellt. Die Schichtdicken der Mischschichten betragen 10nm (durchgezogene Kennlinien, Hell-und Dunkelkennlinien) und 20nm (gestrichelte Kennlinien, Hell-und Dunkelkennlinien.

In diesem Fall ist das Bauelement mit der dickeren Mischschicht deutlich das bessere Bauelement: Der Kurzschlussstrom ist deutlich größer und der Füllfaktor ist nur wenig geringer geworden, so dass das Bauelement mit der dickeren Mischschicht einen größeren Wirkungsgrad hat.

### Ausführungsbeispiel g)

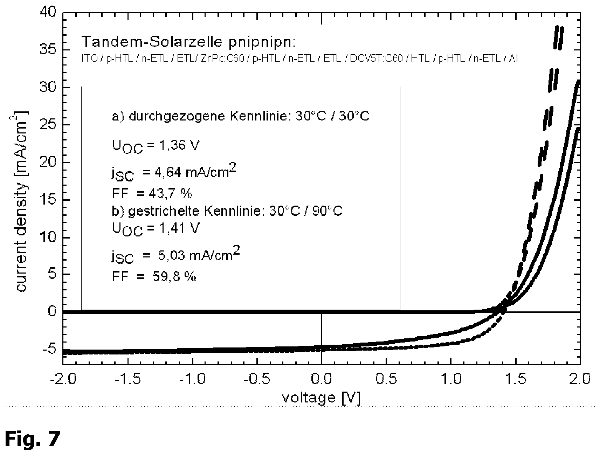

In einem weiteren Ausführungsbeispiel wird in Fig. 7 eine pnipnipn-Tandemzelle mit Mischschichten ZnPc:C60 und DCV5T:C60 verwendet, wobei die Mischschichten bei 30°C bzw. 90°C Substrattemperatur aufgebracht worden sind. Die Struktur der Tandemzelle ist ITO/ p-HTL/ n-ETL/ ETL/ ZnPc:C60/ p-HTL/ n-ETL/ ETL/ DCV5T:C60/ HTL/ p-HTL/ n-ET/ Al.

Bei der einen Solarzelle (durchgezogene Kennlinie) wurde die ZnPc:C60 Mischschicht bei 30°C und auch die DCV5T:C60 bei 30°C Substrattemperatur hergestellt. Bei der zweiten Solarzelle (gestrichelte Kennlinie) wurde dagegen die ZnPc:C60 Mischschicht bei 30°C und die DCV5T:C60 bei 90°C Substrattemperatur hergestellt. Deutlich zu erkennen ist, dass die zweite Solarzelle über einen wesentlichen besseren Füllfaktor verfügt und damit das Bauelement einen deutlich besseren Wirkungsgrad hat.

## Patentansprüche

1. Organisches photoaktives Bauelement mit einer Anode und einer Kathode und mindestens einem zwischen den Elektroden angeordneten organischen photoaktiven intrinsischen i-Schichtsystem zur Erzeugung von gebundene Elektron-Loch-Paaren bei Einfall von Licht, **dadurch gekennzeichnet, dass**
(i) das photoaktive i-Schichtsystem mindestens eine Mischschicht aus mindestens einem Donator-Material zur Aufnahme der Löcher und einem Akzeptor-Material zur Aufnahme von Elektronen, die ein Donator-Akzeptor-System bilden, zur Trennung der gebundenen Elektron-Loch-Paare an den Domänengrenzen enthält,
(ii) es sich bei dem Donator-Material und dem Akzeptor-Material der Mischschicht um nicht-polymere Materialien handelt,
(iii) das Donator-Material eine Verdampfungs-Temperatur im Vakuum hat, die um mindestens 150°C tiefer liegt als die Verdampfungs-Temperatur im Vakuum des Akzeptor-Materials, wobei als Verdampfungstemperatur die Temperatur verstanden wird, um bei einer gegebenen Verdampfergeometrie und einem Vakuum im Bereich 10⁻⁴ bis 10⁻¹⁰ mbar eine Aufdampfrate von 0,1 nm/s an der Position des Substrats zu erreichen, und
(iv) eine invertierte Schichtfolge, bei der die photogenerierten Elektronen die Mischschicht in Richtung auf das Substrat hin verlassen aus einer n-i-p, i-p oder n-i Struktur aus jeweils einem n-, i- oder p-Schichtsystem aufweist, wobei n eine n-leitende Schicht und p eine p-leitende Schicht bezeichnen und wobei das organische photoaktive i-Schichtsystem direkt auf der Kathode oder auf einem elektronenleitenden n-Materialsystem aufgebracht ist.

2. Photoaktives Bauelement nach Anspruch 1, **dadurch gekennzeichnet, dass** das Bauelement ein p- und/oder n-Materialsystem aufweist, welches aus einer oder mehreren Schichten besteht.

3. Photoaktives Bauelement nach einem der Ansprüche 1 oder 2, **dadurch gekennzeichnet, dass** das p- und/oder n-Materialsystem eine oder mehrere dotierte wide-gap Schichten enthält, welche ein Absorptionsmaximum im Wellenlängenbereich <450nm aufweisen.

4. Photoaktives Bauelement nach einem der vorhergehenden Ansprüche, **dadurch gekennzeichnet, dass** Lichtfallen zur Vergrößerung des optischen Weges des einfallenden Lichtes im aktiven System ausgebildet sind.

5. Photoaktives Bauelement nach Anspruch 4, **dadurch gekennzeichnet, dass** die Lichtfalle dadurch realisiert wird, dass eine dotierte wide-gap-Schicht eine glatte Grenzfläche zur i-Schicht und eine periodisch mikrostrukturierte Grenzfläche zum Kontakt hat.

6. Photoaktives Bauelement nach Anspruch 4, **dadurch gekennzeichnet, dass** die Lichtfalle dadurch realisiert wird, dass das Bauelement auf einem periodisch mikrostrukturierten Substrat aufgebaut wird und die homogene Funktion des Bauelements, also eine kurzschlussfreie Kontaktierung und homogene Verteilung des elektrischen Feldes über die gesamte Fläche, durch die Verwendung einer dotierten wide-gap-Schicht gewährleistet wird.

7. Photoaktives Bauelement nach einem der vorhergehenden Ansprüche, **dadurch gekennzeichnet, dass** das Bauelement zwischen der ersten elektronenleitenden Schicht (n-Schicht) und der auf dem Substrat befindlichen Elektrode eine p-dotierte Schicht enthält, so dass es sich um eine pnip oder pni-Struktur handelt.

8. Photoaktives Bauelement nach einem der vorhergehenden Ansprüche, **dadurch gekennzeichnet, dass** das Bauelement zwischen der photoaktiven i-Schicht und der auf dem Substrat befindlichen Elektrode eine p-dotierte Schicht enthält, so dass es sich um eine pip oder pi-Struktur handelt, wobei die zusätzliche p-dotierte Schicht eine Ferminiveaulage hat, die höchstens 0,4eV, bevorzugt aber weniger als 0,3eV unterhalb des Elektronentransportnivaus der i-Schicht liegt.

9. Photoaktives Bauelement nach einem der vorhergehenden Ansprüche, **dadurch gekennzeichnet, dass** das Bauelement ein n-Schichtsystem zwischen der p-dotierten Schicht und der Gegenelektrode enthält, so dass es sich um eine nipn oder ipn-Struktur handelt.

10. Photoaktives Bauelement nach einem der vorhergehenden Ansprüche, **dadurch gekennzeichnet, dass** das Bauelement ein n-Schichtsystem zwischen der photoaktiven i-Schicht und der Gegenelektrode enthält, so dass es sich um eine nin- oder in-Struktur handelt, wobei die zusätzliche n-dotierte Schicht eine Ferminiveaulage hat, die höchstens 0,4eV, bevorzugt aber weniger als 0,3eV oberhalb des Löchertransportnivaus der i-Schicht liegt.

11. Photoaktives Bauelement nach einem der vorhergehenden Ansprüche, **dadurch gekennzeichnet, dass** das Bauelement ein n-Schichtsystem und/oder ein p-Schichtsystem enthält, so dass es sich um eine pnipn, pnin, pipn- oder p-i-n-Struktur handelt.

12. Photoaktives Bauelement nach einem der Ansprüche 7 bis 11, **dadurch gekennzeichnet, dass** das zusätzliche p-Materialsystem und/oder das zusätzliche n-Materialsystem eine oder mehrere dotierte wide-gap Schichten enthält.

13. Photoaktives Bauelement nach einem der vorhergehenden Ansprüche, **dadurch gekennzeichnet, dass** das Bauelement noch weitere n-Schichtsysteme und/oder p-Schichtsysteme enthält, so das es sich z.B. um eine npnipn, pnipnp, npnipnp, pnpnipnpn oder pnpnpnipnpnpn -Struktur handelt.

14. Photoaktives Bauelement nach Anspruch 13, **dadurch gekennzeichnet, dass** eines oder mehrere der weiteren p-Materialsysteme und/oder der weiteren n-Materialsysteme eine oder mehrere dotierte wide-gap Schichten enthält.

15. Photoaktives Bauelement nach einem der vorhergehenden Ansprüche, **dadurch gekennzeichnet, dass** es sich bei dem Bauelement um eine Tandem- oder Mehrfachzelle aus einer Kombination aus nip, ni, ip, pnip, pni, pip, nipn, nin, ipn, pnipn, pnin oder pipn-Strukturen handelt.

16. Verfahren zur Herstellung eines photoaktiven Bauelements nach einem der Ansprüche 1 bis 15, welches folgende Schritte umfasst:
- Bereitstellen eines Substrats mit einer Kathode
- Erwärmen des Substrats
- Co-verdampfen des Donator- und des Akzeptormaterials,
wobei ein interpretierendes Netzwerk als i-Schicht gebildet wird, und
- Auftragen einer Anode auf die i-Schicht.

17. Verfahren nach Anspruch 16, wobei das Substrat auf 70 bis 140 °C erwärmt wird.

## Claims

1. Organic photoactive component comprising an anode and a cathode and at least one organic photoactive intrinsic i-layer system arranged between the electrodes for producing bound electron-hole pairs in the case of incident light, **characterized in that**
(i) the photoactive i-layer system contains at least one mixed layer composed of at least one donor material for taking up the holes and one acceptor material for taking up electrons and the materials form a donor-acceptor system for separating the bound electron-hole pairs at the domain boundaries,
(ii) the donor material and the acceptor material of the mixed layer are non-polymeric materials,
(iii) the donor material has an evaporation temperature in a vacuum which is at least 150°C lower than the evaporation temperature in a vacuum of the acceptor material, wherein evaporation temperature is understood to mean that temperature which is required in order to achieve a vapor deposition rate of 0.1 nm/s at the position of the substrate for a given evaporator geometry and a vacuum in the range of from 10⁻⁴ to 10⁻¹⁰ mbar, and
(iv) has an inverted layer sequence in which the photogenerated electrons leave the mixed layer in the direction of the substrate and which is composed of an n-i-p, i-p or n-i structure composed in each case of an n-, i- or p-layer system, wherein n denotes an n-conducting layer and p denotes a p-conducting layer and wherein the organic photoactive i-layer system is applied directly on the cathode or on an electron-conducting n-material system.

2. Photoactive component according to Claim 1, **characterized in that** the component comprises a p- and/or n-material system consisting of one or more layers.

3. Photoactive component according to either of Claims 1 and 2, **characterized in that** the p- and/or n-material system contains one or more doped wide-gap layers having an absorption maximum in the wavelength range of <450 nm.

4. Photoactive component according to any of the preceding claims, **characterized in that** light traps for enlarging the optical path of the incident light are formed in the active system.

5. Photoactive component according to Claim 4, **characterized in that** the light trap is realized **in that** a doped wide-gap layer has a smooth interface with respect to the i-layer and a periodically microstructured interface with respect to the contact.

6. Photoactive component according to Claim 4, **characterized in that** the light trap is realized by virtue of the fact that the component is constructed on a periodically microstructured substrate and the homogeneous function of the component, that is to say a short-circuit-free contact-connection and homogeneous distribution of the electric field over the entire area, is ensured by the use of a doped wide-gap layer.

7. Photoactive component according to any of the preceding claims, **characterized in that** the component contains a p-doped layer between the first electron-conducting layer (n-layer) and the electrode situated on the substrate, with the result that a pnip or pni structure is involved.

8. Photoactive component according to any of the preceding claims, **characterized in that** the component contains a p-doped layer between the photoactive i-layer and the electrode situated on the substrate, with the result that a pip or pi structure is involved, wherein the additional p-doped layer has a Fermi level situated at most 0.4 eV, but preferably less than 0.3 eV, below the electron transport level of the i-layer.

9. Photoactive component according to any of the preceding claims, **characterized in that** the component contains an n-layer system between the p-doped layer and the counterelectrode, with the result that an nipn or ipn structure is involved.

10. Photoactive component according to any of the preceding claims, **characterized in that** the component contains an n-layer system between the photoactive i-layer and the counterelectrode, with the result that a nin or in structure is involved, wherein the additional n-doped layer has a Fermi level situated at most 0.4 eV, but preferably less than 0.3 eV, above the hole transport level of the i-layer.

11. Photoactive component according to any of the preceding claims, **characterized in that** the component contains an n-layer system and/or a p-layer system, with the result that a pnipn, pnin, pipn or p-i-n structure is involved.

12. Photoactive component according to any of Claims 7 to 11, **characterized in that** the additional p-material system and/or the additional n-material system contains one or more doped wide-gap layers.

13. Photoactive component according to any of the preceding claims, **characterized in that** the component contains further n-layer systems and/or p-layer systems, with the result that e.g. an npnipn, pnipnp, npnipnp, pnpnipnpn or pnpnpnipnpnpn structure is involved.

14. Photoactive component according to Claim 13, **characterized in that** one or more of the further p-material systems and/or of the further n-material systems contain(s) one or more doped wide-gap layers.

15. Photoactive component according to any of the preceding claims, **characterized in that** the component is a tandem or multiple cell composed of a combination of nip, ni, ip, pnip, pni, pip, nipn, nin, ipn, pnipn, pnin or pipn structures.

16. Method for producing a photoactive component according to any of Claims 1 to 15 comprising the following steps:
- providing a substrate with a cathode,
- heating the substrate,
- co-evaporating the donor material and acceptor material, wherein an interpreting network is formed as i-layer, and
- applying an anode to the i-layer.

17. Method according to Claim 16, wherein the substrate is heated to 70 to 140°C.

## Revendications

1. Composant organique photoactif présentant une anode et une cathode ainsi qu'un système organique photoactif stratifié de couches intrinsèquement i capable de former sous l'action de la lumière incidente des paires électron-trou liés,
**caractérisé en ce que**
(i) le système photoactif de couches i contient au moins une couche mixte formée d'au moins un matériau donneur qui reprend les trous et d'un matériau accepteur qui reprend les électrons, ces matériaux formant un système donneur-accepteur qui rompt au niveau des frontières entre les domaines les paires électron-trou liés,
(ii) **en ce que** le matériau donneur et le matériau accepteur de la couche mixte sont des matériaux non polymères,
(iii) **en ce que** le matériau donneur présente une température de vaporisation dans le vide au moins 150°C plus basse que la température de vaporisation dans le vide du matériau accepteur, la température de vaporisation étant celle qui permet d'atteindre pour une géométrie d'évaporateur donnée et un vide de l'ordre de 10⁻⁴ à 10⁻¹⁰ mbar un taux de vaporisation de 0,1 nm/s au niveau du substrat,
(iv) **en ce qu'**une succession inversée de couches dans laquelle les électrons photogénérés quittent la couche mixte en direction du substrat à partir d'une structure n-i-p, i-p ou n-i d'un système de couches n, i ou p, n désignant une couche à conduction n et p une couche à conduction p et le système organique photoactif de couches i étant appliqué directement sur un système de matériaux n conduisant les électrons.

2. Composant photoactif selon la revendication 1, **caractérisé en ce que** le composant présente un système de matériaux p ou n constitué d'une ou de plusieurs couches.

3. Composant photoactif selon l'une des revendications 1 ou 2, **caractérisé en ce que** le système de matériaux p ou n contient une ou plusieurs couches dopées à larges interstices qui présentent un maximum d'absorption dans la plage des longueurs d'onde < 450 nm.

4. Composant photoactif selon l'une des revendications précédentes, **caractérisé en ce que** des pièges à lumière qui allongent le parcours optique de la lumière incidente sont formés dans le système actif.

5. Composant photoactif selon la revendication 4, **caractérisé en ce que** les pièges à lumière sont réalisés en donnant à une couche dopée à larges interstices une surface frontière lisse vis-à-vis de la couche i et une surface frontière microstructurée de manière périodique vis-à-vis du contact.

6. Composant photoactif selon la revendication 4, **caractérisé en ce que** les pièges à lumière sont réalisés en formant le composant sur un substrat microstructuré de manière périodique et en assurant un fonctionnement homogène du composant, à savoir un contact sans court-circuit et une répartition homogène du champ électrique sur toute la surface par le recours à une couche dopée à larges interstices.

7. Composant photoactif selon l'une des revendications précédentes, **caractérisé en ce que** le composant contient une couche à dopage p située entre la première couche conductrice d'électrons (couche n) et l'électrode située sur le substrat, de sorte que la structure est pnip ou pni.

8. Composant photoactif selon l'une des revendications précédentes, **caractérisé en ce que** le composant contient une couche à dopage p entre la couche i photoactive et l'électrode située sur le substrat, de sorte que la structure est pip ou pi, la couche supplémentaire à dopage p présentant un niveau de Fermi situé au plus à 0,4 eV mais de préférence à moins de 0,3 eV en-dessous du niveau de transport des électrons de la couche i.

9. Composant photoactif selon l'une des revendications précédentes, **caractérisé en ce que** le composant contient un système de couches n entre la couche à dopage p et la contre-électrode, de sorte de la structure est nipn ou ipn.

10. Composant photoactif selon l'une des revendications précédentes, **caractérisé en ce que** le composant contient un système de couches n entre la couche photoactive i et la contre-électrode, de sorte de la structure est nin ou in, la couche supplémentaire à dopage n présentant un niveau de Fermi situé au plus à 0,4 eV mais de préférence à moins de 0,3 eV au-dessus du niveau de transport des électrons de la couche i.

11. Composant photoactif selon l'une des revendications précédentes, **caractérisé en ce que** le composant contient un système de couches n et/ou un système de couches p, de sorte de la structure est pnipn, pnin, pipn ou p-i-n.

12. Composant photoactif selon l'une des revendications 7 à 11, **caractérisé en ce que** le système supplémentaire de matériaux p ou le système supplémentaire de matériaux n contient une ou plusieurs couches dopées à larges interstices.

13. Composant photoactif selon l'une des revendications précédentes, **caractérisé en ce que** le composant contient encore d'autres systèmes de couches n et/ou systèmes de couches p, de sorte de la structure est par exemple npnipn, pnipnp, npnipnp, pnpnipnpn ou pnpnpnipnpnpn.

14. Composant photoactif selon la revendication 13, **caractérisé en ce qu'**un ou plusieurs des autres systèmes de matériaux p ou systèmes de matériaux n contient une ou plusieurs couches dopées à larges interstices.

15. Composant photoactif selon la revendication 13, **caractérisé en ce que** le composant est une cellule tandem ou multiple formée d'une combinaison de structures nip, ni, ip, pnip, pni, pip, nipn, nin, ipn, pnipn, pnin ou pipn.

16. Procédé de fabrication d'un composant photoactif selon l'une des revendications 1 à 15, le procédé comprenant les étapes suivantes :
- préparation d'un substrat doté d'une cathode,
- chauffage du substrat,
- co-vaporisation du matériau donneur et du matériau accepteur, ce qui forme un réseau interprété comme couche i et
- application d'une anode sur la couche i.

17. Procédé selon la revendication 16, dans lequel le substrat est chauffé entre 70 et 140°C.
